# EUROPEAN PATENT SPECIFICATION

(11) **EP 2 042 879 B1**
(45) Date of publication and mention of the grant of the patent: **28.12.2011**
(21) Application number: 07425603.3
(22) Date of filing: 28.09.2007
(51) Int. Cl.: G01R 31/36, G01R 1/20, G01R 1/44

(54) **Battery current sensor for a motor vehicle**
Batteriestromsensor für ein Kraftfahrzeug
Capteur de courant de batterie pour véhicule automobile

(43) Date of publication of application: 01.04.2009
(73) Proprietor: Magneti Marelli S.p.A., 20011 Corbetta (MI) (IT)
(72) Inventor: Nepote, Andrea, 10078 Venaria Reale (Torino) (IT); Giraudo, Gabriele, 10078 Venaria Reale (Torino) (IT); Campinoti, Daniele, 10078 Venaria Reale (Torino) (IT)
(74) Representative: Notaro, Giancarlo

(56) References cited:
- WO-A-99/09421
- US-A- 2005 017 760

## Description

The present invention relates to devices for measuring the current of a battery on board a motor vehicle, of the type comprising a resistor or shunt, constituted by a copper plate, which has a known and predetermined value of resistance and is connected in series between a terminal of the battery and a conductor cable associated thereto, and an electronic circuit for measuring the current, designed to determine the battery current and comprising electronic compensation means, which are designed to correct the measured value of current taking into account the variations of resistance of the shunt, which arise as the temperature varies.

A device of the type indicated above is described and illustrated in DE 10 2004 042 719 A1.

The general technical problem that underlies the use of devices of the type indicated above is that of measuring the so-called "state of charge" (SOC) of a battery on board a motor vehicle as well as to evaluate its "state of health" (SOH) and its "state of function" (SOF), i.e., how well it is able to perform its task, particularly upon starting of the engine of the motor vehicle.

Said detections imply measurement of the voltage across the battery and of the temperature and current supplied or absorbed by the battery. The determination of the voltage does not entail any particular problems. The determination of the temperature is carried out in any suitable way, for example using thermocouples or thermistors or sensing circuits. The solution of the problem of measuring the current is not, instead, straightforward, for the reasons outlined in what follows.

The range of variability of the current of the battery is extremely wide, there being required the measurement in various operating steps of the vehicle. There can, for example, be required a measurement from a maximum of 1 A with a level of accepted noise of 10 mAₚₚ (for example, with ignition key in the ON position and engine turned off) up to 1500 A, during starting of the engine. The requirement of high current imposes the need to use a very low resistance, typically of the order of 100 µΩ so as to contain the power dissipation (225W for a few seconds, in the example considered). On the other hand, the use of a value of resistance that is so low sets problems of signal-to-noise ratio on the values of voltage detected across of the resistance as well as of sensitivity of the electronics for signal conditioning and conversion. By way of example, a noise level of 10 mAₚₚ on a resistance of 100 µΩ is equivalent to a voltage signal of 1 µV.

Added to the aforesaid problems is the need for independence of the value detected from the temperature, which is subject to wide variations, in particular in the (usual) case where the battery is housed in the engine compartment of the motor vehicle. The solution adopted in the most conventional devices consists in making the shunt functioning as detection element of a material, the electrical resistance of which will present an extremely low variation in the range of temperature required, such as, for example, manganine.

Illustrated in the document No. DE 10 2004 042 719 A1 already referred to above is a solution in which, instead, the detection element is made of copper and moreover provided in which is a suitable electronics for correcting the detected value of current in order to take into account the variation in resistance of the shunt as the temperature varies.

A device as indicated in the preamble of claim 1 is known from WO 99/09421 A and US 2005/017760.

The purpose of the present invention to propose an efficient solution to all the problems set forth above, in particular guaranteeing a precise measurement of the battery current to be obtained with simple and low-cost means.

With a view to achieving said purpose, the subject of the invention is a device and a method having all the characteristics indicated in claim 1 and claim 9.

The pre-determined condition of arrest of the iterative process can be identified when the condition is reached where the values of current determined in two successive cycles of the iterative process differ from one another by an amount smaller than a pre-set amount; or else the condition of arrest of the iterations can be identified when a pre-determined number of successive iterations of the process is reached, or else again it can be based upon a combination of the two methodologies mentioned above; i.e., it can be identified when a variation smaller than a pre-set amount is reached between the values of current detected in two successive iterations, but with a maximum limit of iterations that can be performed.

The value of current at output of the sensor device can be the weighted-mean value of the last n iterations, or else the last calculated value.

According to a further strategy, additional to the one set forth above, the value of current is determined once again on the basis of a thermal model, but without any iterations. According to said modality, the variation in temperature of the resistive element with respect to an appropriate reference temperature is in the first place detected as a function of time. The variation in temperature is due to the power dissipated by the current that flows through the resistive element. The variation in temperature has an evolution in time of an exponential type, which differs for each value of current. As the current increases, and hence the power dissipated increases, the time derivative of the temperature and the steady-state value of the temperature increase. According to said modality, the value of current is then calculated on the basis of a thermal model, as a function of the variation of the temperature in time, without the need for iterations in the process of calculation.

The subject of the invention is both the measuring device described above and the measuring method implemented therein.

Further characteristics and advantages of the invention will emerge from the ensuing description with reference to the annexed plates of drawings, which are provided purely by way of non-limiting example, and in which:
- Figure 1 is a schematic cross-sectional view, according to the line I-I of Figure 2, of a terminal of a battery of a motor vehicle incorporating the device according to the invention;
- Figure 2 is a view of a detail of the device 1, according to the line II-II of Figure 1;
- Figure 3 illustrates a variant of the detail of Figure 2;
- Figure 4 illustrates a second embodiment of the device according to the invention;
- Figure 5 is a view of a detail of the device of Figure 4, according to the line V-V;
- Figure 6 illustrates a variant of the detail of Figure 5;
- Figure 7 is a block diagram that illustrates the principle underlying the present invention;
- Figure 8 is a flowchart that illustrates the iterative method according to the present invention;
- Figure 9 illustrates a diagram that represents the principle underlying the modalities of non-iterative calculation according to the present invention; and
- Figure 10 illustrates a flowchart of the modalities of non-iterative calculation according to the present invention.

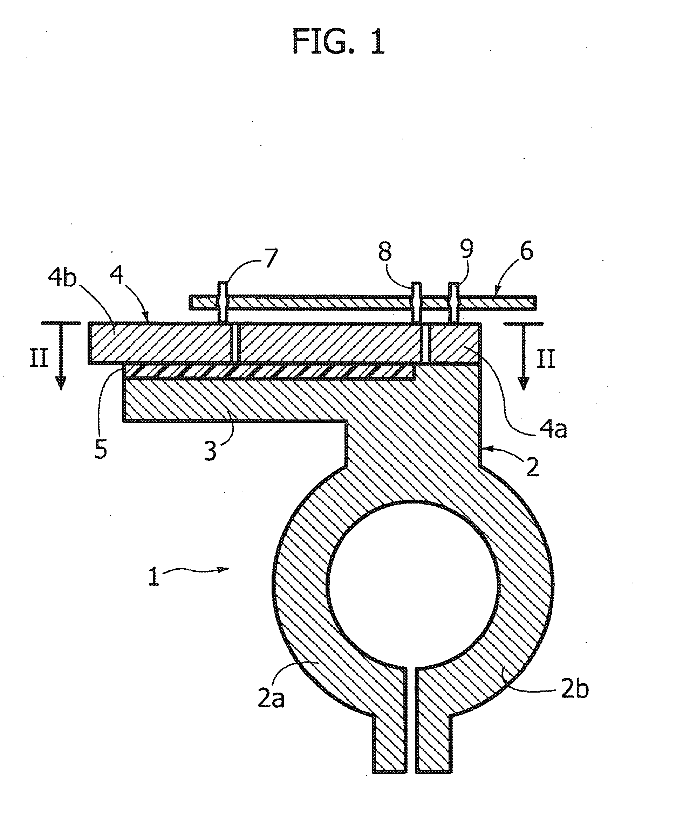

With reference to Figure 1, designated as a whole by 1 is a terminal of a battery of a motor vehicle comprising a body 2, in itself of a known type, made, for example, of brass, having two terminal arms 2a, 2b which can be elastically deformed so as to grip between them a terminal of the battery, and a base plate 3. The reference number 4 designates as a whole an element for detection of the battery current, or shunt, constituted by a copper plate joined to the plate 3 of the terminal using any known technique, with the interposition of a layer of insulating material 5 that is interrupted in an area of direct contact between the body 2 of the terminal and the plate 4, at one end 4a of the plate 4. The opposite end 4b of the plate 4 is designed to be connected to a conductor cable (not illustrated). The reference number 6 designates an electronic card electrically connected to the plate 4 constituting the current-detection element by means of three connection pins 7, 8, 9. The electronic card 6 is provided with an electronic circuit for measuring the current including compensation means, which are designed to correct the detected value of current as a function of the temperature so as to take into account the variation in resistance of the copper plate 4 that arises as the temperature varies.

In a concrete embodiment of the device illustrated, the resistance of the element 4 at room temperature is 100 µΩ, said element being pre-arranged for detecting currents up to a maximum value of 1500 A with a voltage of 150 mV.

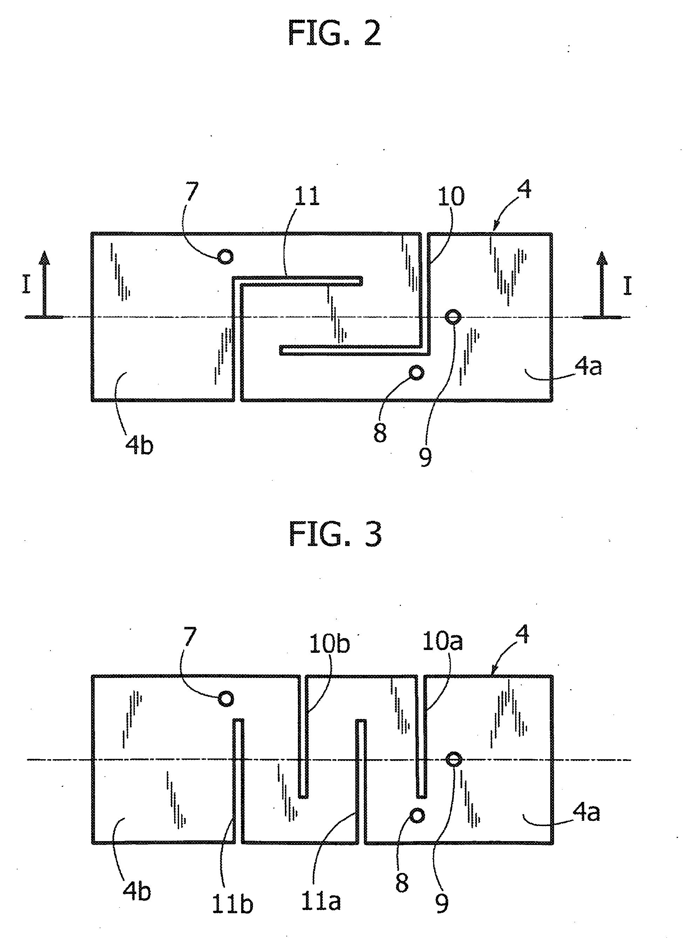

As illustrated in Figure 2, the copper plate 4 has notches 10, 11, which are designed to define a labyrinthine path for the current that flows from the end 4a to the end 4b of the copper plate 4, in such a way that, for given dimensions of the plate 4, a lengthening of the path of the current is obtained with consequent increase in the resistance of the sensor element. Figure 3 illustrates a variant in which notches 10a, 10b, 11a, 11b are provided, which define a serpentine path for the current through the plate 4.

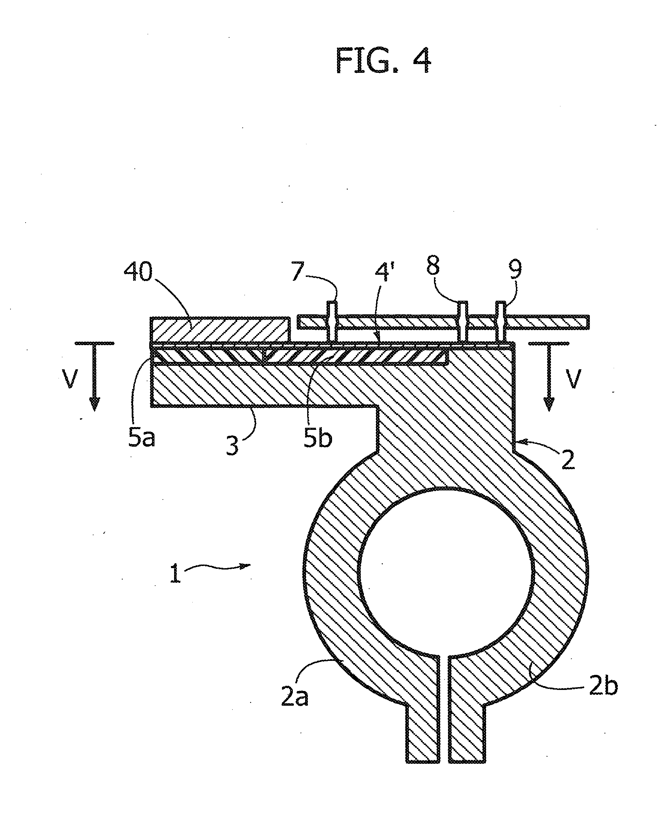

Figure 4 illustrates a second embodiment that is conceptually identical to the embodiment of Figure 1, but differs from this from a constructional standpoint in that therein the current-detection element is constituted by a copper lamina or strap 4' of a thickness smaller than the thickness of a part of copper 40 used for connection to the conductor cable. A further difference with respect to the embodiment of Figure 1 lies in the fact that in this case the layer of insulating material is constituted by a more rigid portion 5a, which enables fixing of the connection part 40, for example by means of screws, and a less rigid part 5b. In Figure 4, the parts that are in common with those of Figure 1 are designated by the same reference numbers.

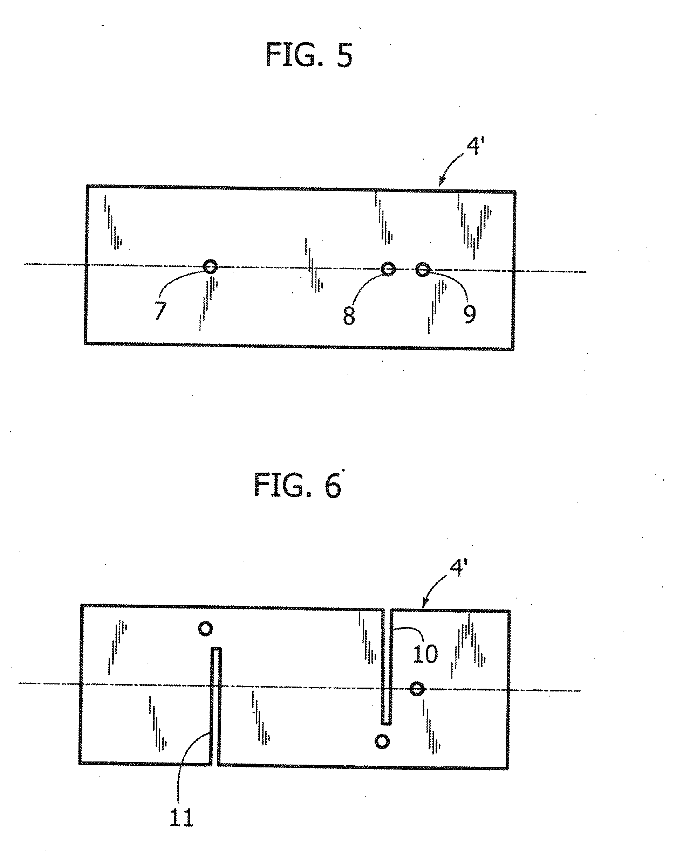

The use of a thin strap of the same type as the strap 4' illustrated in Figure 4 enables an increase in the value of resistance of the sensor element 4'. For this reason, in this case the strap 4' can also be without notches of the same type as the notches 10, 11 illustrated in Figures 2 and 3. Said solution is in any case possible, and a possible embodiment is illustrated in Figure 6. In this case, there is consequently obtained an increase in the value of the resistance both on account of the reduced thickness of the strap 4' and on account of the fact that a labyrinthine path is defined for the current through the strap.

The sensor device of the same type as the copper plate 4 or as the copper strap 4' of Figures 1, 4 can be used for detecting the battery current. This can be obtained in so far as the card 6 is pre-arranged for detecting the voltage across the sensor element and is programmed for performing the calculation of the current on the basis of Ohm's law (electrical model) on the basis of the pre-determined known value of the resistance of the sensor element. As already discussed above, however, there exists the problem of compensating for the errors of measurement of the current due to the variations of resistance of the sensor 4 that arise with the marked temperature variations to which the shunt is subject, above all during the step of starting of the engine of the motor vehicle.

In the invention, the temperature of the shunt is detected with an indirect measurement, since a direct measurement is technically complicated on account of the high values of temperature reached. The temperature of the copper constituting the plate 4 or the strap 4' depends upon the power dissipated by the copper and upon the time elapsed. An estimation of this temperature can consequently be obtained knowing the value of the power dissipated, the time elapsed, the temperature of any point of the system and the thermal model of the system.

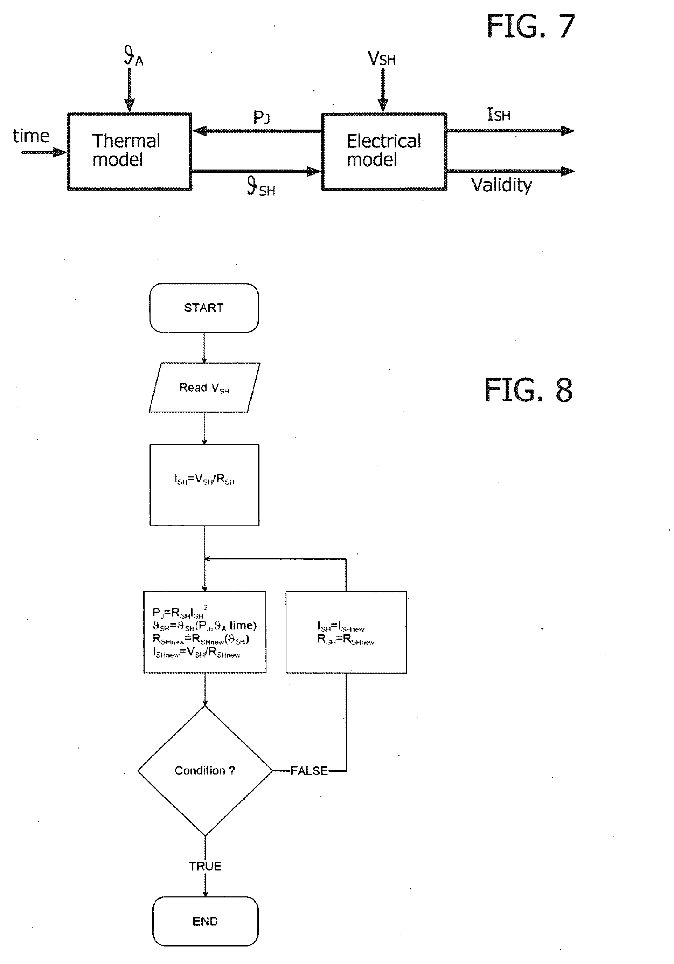

The power dissipated depends upon the current that flows in the copper plate or in the copper strap. Said current is measured by indirect measurement of the voltage on the shunt and consequently depends upon its resistance, which is a function of the temperature. This leads to having two models (a thermal model and an electrical model), which interact as highlighted in Figure 7. In said figure, the symbol V_{SH} designates the voltage across the sensor element or shunt, the symbol Pⱼ designates the power dissipated in the shunt, the symbol θ_{A} designates the reference temperature, the symbol t designates time, the symbol θ_{SH} designates the temperature of the shunt, and the symbol I_{SH} designates the current that flows through the shunt.

With reference to Figure 7 and Figure 8, the solution of the system can be obtained using an iterative method that returns at output the value of current and a signal of validity of the value itself. With reference in particular to the flowchart of Figure 8, the method envisages in the first place detection of the voltage V_{SH} across the shunt to be carried out. On the basis of the detected voltage value, the system calculates the value of current I_{SH}=V_{SH}/R_{SH}. Once a value of current has been determined, it is possible to calculate the value of the power dissipated Pⱼ on the basis of the pre-determined known value of the resistance of the shunt and of the calculated value of current. At this point, on the basis of the value of the power dissipated, of the time elapsed, and of the starting temperature of the shunt, it is thus possible, thanks to a thermal model (which must be preliminarily derived empirically for a given embodiment and calibrated via simulations and experimental tests), to calculate the current temperature of the shunt. Once the new value of the shunt has been determined, the value of resistance of the shunt itself as a function of the variation in temperature is recalculated, which makes it possible to obtain a new value of current. The cycle of the aforesaid operations is repeated n times until a condition of arrest of the iterations is reached. The condition of arrest can be identified as a condition being reached in which the values of current determined at the end of two successive iterations differ from one another by an amount smaller than a pre-set amount, or else it can be identified in the execution of a pre-set number of iterations. Also possible is a combined strategy based upon the closeness of the values of current determined in two successive iterations, but with a maximum limit to the number of iterations.

As value of current at output the weighted-mean value of the last n iterations can be considered, or else the last calculated value.

According to a modality additional to the one illustrated above, the system according to the invention envisages a non-iterative calculation method, in which the value of current is determined on the basis of the temperature of the resistive element or shunt and of the time elapsed.

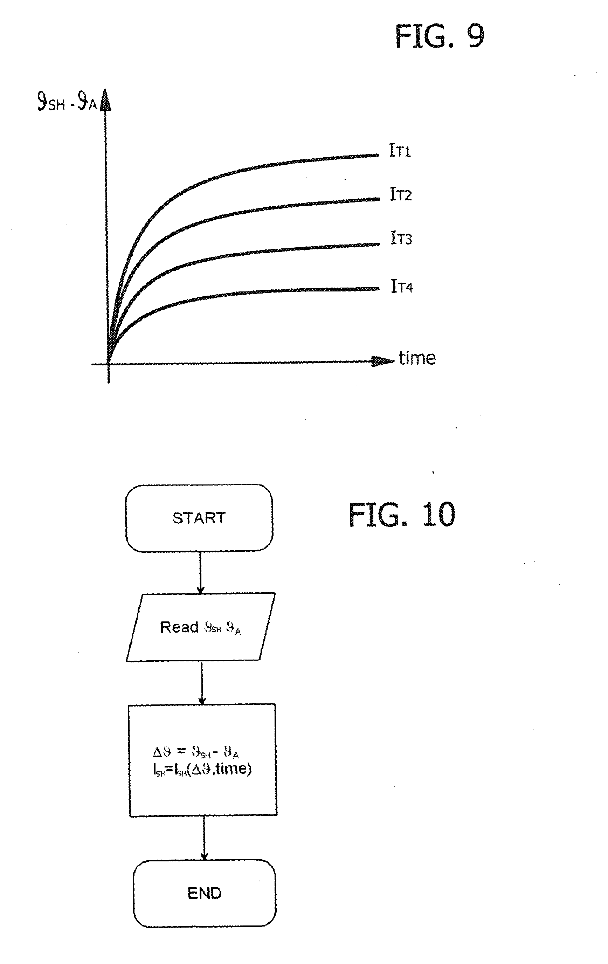

In a resistive element of known resistance R flowing in which is a current I, the power dissipated is Pⱼ=RI². This power produces an increase in temperature of the resistive element θ_{SH} with respect to a reference temperature θ_{A}. The variation in temperature θ_{SH}-θ_{A} has an evolution in time of an exponential type. As the power dissipated, and hence the current, increases the derivative of the temperature and its steady-state value increase, as illustrated in the diagram of Figure 9. With reference to said diagram, it may be noted that for a given value of (θ_{SH}-θ_{A}) and for a given value of the time elapsed a single value of current is identified in the resistive element (i.e., a single curve in the diagram). According to said approach, the method of calculation envisages the operations illustrated schematically in the flowchart of Figure 10. As may be seen, the method starts with determination of the temperature of a reference point θ_{A} and with monitoring of the variation in temperature θ_{SH} as the time t varies. The current is calculated, on the basis of the thermal model set in the system, as a function of the variation θ_{SH}-θ_{A} in time. The measurement of the resistive element hence makes it possible to take into account directly in the thermal model the variation of R and hence to obtain at output I_{R} without the need for further iterations. Considering that the measurement of the current is obtained via a measurement of temperature it is hence not necessary, strictly speaking, to measure the voltage across the resistance. The measurement of the voltage is, however, necessary for evaluating whether the calculated value of current regards a current supplied by the battery or an absorbed current.

The temperature measurement can be carried out using detection means pre-arranged on the card 6, for example constituted by thermistors, or thermocouples, or temperature-sensing circuits.

As emerges clearly from the foregoing description, the device and the method according to the invention enable precise measurements of the battery current to be obtained with a structure that is extremely simple and of low cost.

Of course, without prejudice to the principle of the invention, the details of construction and the embodiments may vary widely with respect to what is described and illustrated herein purely by way of example, without thereby departing from the scope of the present invention as defined by the appended claims.

## Claims

1. A device for measuring the current of a battery on board a motor vehicle, comprising a resistor or shunt (4, 4'), constituted by a copper plate having a pre-determined known resistance connected in series between a terminal (1) of the battery and a conductor cable associated thereto, and an electronic circuit for measuring the current (6), comprising electronic compensation means, which are designed to correct the measured value of current taking into account the variations of resistance of the shunt that arise as the temperature varies,
wherein said electronic compensation means are programmed for correcting the value of current on the basis of a model that represents the relationship between the power dissipated in the shunt and the thermal condition thereof,
**characterized in that** said electronic compensation means are programmed for applying said thermal model with an iterative process, in which the following operations are executed cyclically:
- detection of the voltage (V_{SH}) across the shunt (4, 4');
- calculation of a value of current (I_{SH}) on the basis of the detected voltage value (V_{SH}) and of the known value (R_{SH}) of the resistance of the shunt (4, 4');
- calculation of the dissipated power (Pⱼ) on the basis of the known value of the resistance (R_{SH}) of the shunt and of the calculated value (I_{SH}) of the current;
- calculation of the temperature of the shunt (θ_{SH}) starting from a reference temperature value (θ_{A}), from the dissipated power (Pⱼ) and from the time elapsed (t), thanks to the aforesaid thermal model; and
- recalculation of a new value of the resistance of the shunt (R_{SH}) on the basis of the calculated value of its temperature (θ_{SH}),
said operations being repeated cyclically n times until a condition of arrest is reached.

2. The device according to Claim 1, in which said condition of arrest corresponds to a condition in which the values of current determined with two successive cycles of operations differ from one another by an amount smaller than a pre-set amount.

3. The device according to Claim 1, **characterized in that** the aforesaid condition of arrest corresponds to the completion of a pre-set number of iterations.

4. The device according to Claim 1, **characterized in that** said condition of arrest corresponds to a condition in which the values of current determined with two successive cycles of operations differ from one another by an amount smaller than a pre-set amount or to completion of a pre-set number of iterations, in the case where the first condition has not been yet reached.

5. The device according to Claim 1, **characterized in that** said electronic compensation means are programmed for determining the value of current also on the basis of a thermal model, without iterations, detecting the variation of the temperature of the resistive element with respect to an appropriate reference temperature as a function of time and calculating the value of current on the basis of the thermal model as a function of the variation of the temperature in time.

6. The device according to any one of the preceding claims, **characterized in that** the sensor element is constituted by a copper plate (4) directly connected to the terminal of the battery and incorporating a part (4b) for connection to the conductor cable.

7. The device according to any one of Claims 1-5, **characterized in that** the sensor or shunt element is constituted by a copper lamina or strap (4') having a thickness smaller than a terminal copper part (40) having the purpose of connection to the conductor cable.

8. The device according to Claim 6 or Claim 7, **characterized in that** the sensor element has notches (10, 11, 10a, 11a, 10b, 11b) that define a labyrinthine path or serpentine path for the current that traverses the sensor element.

9. A method for measuring the current of a battery on board a motor vehicle, in which a resistor or shunt (4, 4') is provided, constituted by a copper plate having a pre-determined known resistance connected in series between a terminal of the battery and a conductor cable associated thereto, made in which is an electronic circuit for measuring the current, which is designed to determine the battery current and comprises electronic compensation means, which are designed to correct the measured value of current taking into account the variations of resistance of the shunt (4, 4') that arise as the temperature varies, wherein
the value of current is corrected on the basis of a thermal model that represents the relationship between the power dissipated in the shunt (4, 4') and the thermal condition thereof,
**characterized in that** said thermal model is applied with an iterative process in which the following operations are executed cyclically:
- detection of the voltage (V_{SH}) across the shunt (4, 4');
- calculation of a value of current (I_{SH}) on the basis of the detected voltage value (V_{SH}) and of the known value (R_{SH}) of the resistance of the shunt (4, 4');
- calculation of the dissipated power (Pⱼ) on the basis of the known value of the resistance (R_{SH}) of the shunt and of the calculated value (I_{SH}) of the current;
- calculation of the temperature of the shunt (θ_{SH}) starting from a reference temperature value (θ_{A}), from the dissipated power (Pⱼ) and from the time elapsed (t), thanks to the aforesaid thermal model; and
- recalculation of a new value of the resistance of the shunt (R_{SH}) on the basis of the calculated value of its temperature (θ_{SH}), said operations being repeated cyclically n times until a condition of arrest is reached.

10. The method according to Claim 9, **characterized in that** said thermal model is applied also with a non-iterative process, in which a starting reference temperature (θ_{A}) is detected, the variation in temperature of the sensor element or shunt (4, 4') (θ_{SH}) with respect to said reference temperature (θ_{A}) is detected as a function of time, and the value of current is directly calculated on the basis of the detected variation in time of the temperature.

## Patentansprüche

1. Vorrichtung zum Messen des Stroms einer Batterie an Bord eines Kraftfahrzeugs, die einen Widerstand oder eine Nebenschlussleitung (4, 4'), der bzw. die durch eine Kupferplatte mit einem vorgegebenen bekannten Widerstand, die zwischen einen Anschluss (1) der Batterie und ein ihm zugeordnetes Leiterkabel in Reihe geschaltet ist, gebildet ist, und eine elektronische Schaltung zum Messen des Stroms (6), die elektronische Kompensationsmittel enthält, die entworfen sind, um den gemessenen Wert des Stroms unter Berücksichtigung der Schwankungen des Widerstands der Nebenschlussleitung, die mit einer sich verändernden Temperatur einhergehen, zu korrigieren, umfasst,
wobei die elektronischen Kompensationsmittel programmiert sind, um den Wert des Stroms anhand eines Modells zu korrigieren, das die Beziehung zwischen der in der Nebenschlussleitung dissipativ abgeführten Leistung und deren thermischen Zustand repräsentiert,
**dadurch gekennzeichnet, dass** die elektronischen Kompensationsmittel programmiert sind, um das thermische Modell in einem iterativen Prozess anzuwenden, indem die folgenden Operationen zyklisch ausgeführt werden:
- Detektieren der Spannung (V_{SH}) über der Nebenschlussleitung (4, 4');
- Berechnen eines Stromwerts (I_{SH}) anhand des detektierten Spannungswerts (V_{SH}) und des bekannten Werts (R_{SH}) des Widerstands der Nebenschlussleitung (4, 4');
- Berechnen der abgeführten Leistung (Pⱼ) anhand des bekannten Werts des Widerstands (R_{SH}) der Nebenschlussleitung und des berechneten Werts (I_{SH}) des Stroms;
- Berechnen der Temperatur der Nebenschlussleitung (θ_{SH}) ausgehend von einem Referenztemperaturwert (θ_{A}), der abgeführten Leistung (Pⱼ) und der verstrichenen Zeit (t) kraft des oben genannten thermischen Modells; und
- erneutes Berechnen eines neuen Werts des Widerstands der Nebenschlussleitung (R_{SH}) anhand des berechneten Wertes ihrer Temperatur (θ_{SH}),
wobei die Operationen n-mal zyklisch wiederholt werden, bis eine Anhaltebedingung erreicht ist.

2. Vorrichtung nach Anspruch 1, wobei der Haltezustand einem Zustand entspricht, in dem sich die Werte des Stroms, die in zwei aufeinander folgenden Operationszyklen bestimmt werden, voneinander um einen Betrag unterscheiden, der kleiner als ein im Voraus festgelegter Betrag ist.

3. Vorrichtung nach Anspruch 1, **dadurch gekennzeichnet, dass** der oben genannte Haltezustand dem Abschluss einer im Voraus festgelegten Anzahl von Iterationen entspricht.

4. Vorrichtung nach Anspruch 1, **dadurch gekennzeichnet, dass** der Haltezustand einem Zustand entspricht, in dem sich die Werte des Stroms, die in zwei aufeinander folgenden Operationszyklen bestimmt werden, voneinander um einen Betrag unterscheiden, der kleiner als ein im Voraus festgelegter Betrag ist, oder dem Abschluss einer im Voraus festgelegten Anzahl von Iterationen entspricht, falls der erste Zustand noch nicht erreicht worden ist.

5. Vorrichtung nach Anspruch 1, **dadurch gekennzeichnet, dass** die elektronischen Kompensationsmittel programmiert sind, um den Stromwert auch anhand eines thermischen Modells ohne Iterationen zu bestimmen, die Veränderung der Temperatur des Widerstandselements in Bezug auf eine geeignete Referenztemperatur als Funktion der Zeit zu detektieren und den Stromwert anhand des thermischen Modells als Funktion der zeitlichen Veränderung der Temperatur zu berechnen.

6. Vorrichtung nach einem der vorhergehenden Ansprüche, **dadurch gekennzeichnet, dass** das Sensorelement durch eine Kupferplatte (4) gebildet ist, die direkt mit dem Anschluss der Batterie verbunden ist und ein Teil (4b) für die Verbindung mit dem Leiterkabel enthält.

7. Vorrichtung nach einem der Ansprüche 1-5, **dadurch gekennzeichnet, dass** das Sensor- oder Nebenschlussleitungselement durch ein Kupferlaminat oder einen Kupferstreifen (4') gebildet ist, das bzw. der eine Dicke besitzt, die kleiner als ein Anschluss-Kupferteil (40) ist, das den Zweck des Anschlusses an das Leiterkabel hat.

8. Vorrichtung nach Anspruch 6 oder Anspruch 7, **dadurch gekennzeichnet, dass** das Sensorelement Kerben (10, 11, 10a, 11a, 10b, 11b) besitzt, die einen Labyrinth- oder Serpentinenweg für den Strom, der durch das Sensorelement fließt, definieren.

9. Verfahren zum Messen des Stroms einer Batterie an Bord eines Kraftfahrzeugs, wobei ein Widerstand oder eine Nebenschlussleitung (4, 4') vorgesehen ist, der bzw. die durch eine Kupferplatte mit einem vorgegebenen bekannten Widerstand gebildet ist, die zwischen einen Anschluss der Batterie und ein ihm zugeordnetes Leiterkabel in Reihe geschaltet ist, und wobei eine elektronische Schaltung zum Messen des Stroms vorgesehen ist, die entworfen ist, um den Batteriestrom zu bestimmen, und elektronische Kompensationsmittel enthält, die entworfen sind, um den gemessenen Stromwert unter Berücksichtigung der Veränderung des Widerstands der Nebenschlussleitung (4, 4'), die mit Schwankungen der Temperatur einhergehen, zu korrigieren, wobei der Stromwert anhand eines thermischen Modells korrigiert wird, das die Beziehung zwischen der in der Nebenschlussleitung (4, 4') dissipativ abgeführten Leistung und deren thermischen Zustand repräsentiert,
**dadurch gekennzeichnet, dass** das thermische Modell in einem iterativen Prozess angewendet wird, in dem die folgenden Operationen zyklisch ausgeführt werden:
- Detektieren der Spannung (V_{SH}) über der Nebenschlussleitung (4, 4');
- Berechnen eines Stromwerts (I_{SH}) anhand des detektierten Spannungswerts (V_{SH}) und des bekannten Werts (R_{SH}) des Widerstands der Nebenschlussleitung (4, 4');
- Berechnen der abgeführten Leistung (Pⱼ) anhand des bekannten Werts des Widerstands (R_{SH}) der Nebenschlussleitung und des berechneten Werts (I_{SH}) des Stroms;
- Berechnen der Temperatur der Nebenschlussleitung (θ_{SH}) ausgehend von einem Referenztemperaturwert (θ_{A}), der abgeführten Leistung (Pⱼ) und der verstrichenen Zeit (t) kraft des oben genannten thermischen Modells; und
- erneutes Berechnen eines neuen Werts des Widerstandes der Nebenschlussleitung (R_{SH}) anhand des berechneten Werts ihrer Temperatur (θ_{SH}), wobei die Operationen n-mal zyklisch wiederholt werden, bis ein Haltezustand erreicht ist.

10. Verfahren nach Anspruch 9, **dadurch gekennzeichnet, dass** das thermische Modell auch in einem nicht iterativen Prozess angewendet wird, in dem eine Ausgangsreferenztemperatur (θ_{A}) detektiert wird, die Veränderung der Temperatur des Sensorelements oder der Sensornebenschlussleitung (4, 4') (θ_{SH}) in Bezug auf die Referenztemperatur (θ_{A}) als Funktion der Zeit detektiert wird und der Stromwert direkt anhand der detektierten zeitlichen Veränderung der Temperatur berechnet wird.

## Revendications

1. Dispositif pour la mesure du courant de batterie à bord d'un véhicule automobile, comprenant une résistance ou shunt (4, 4'), constituée d'une plaque de cuivre ayant une résistance connue pré-déterminée, connectée en série entre un terminal (1) de la batterie et un câble conducteur associé à celle-ci, et un circuit électronique pour la mesure du courant (6), comprenant des moyens de compensation électroniques, qui sont conçus pour corriger la valeur de courant mesurée, compte tenu des variations de résistance du shunt qui surviennent quand la température varie,
tandis que lesdits moyens de compensation électroniques sont programmés pour corriger la valeur du courant sur la base d'un modèle qui représente la relation entre la puissance dissipée dans le shunt et l'état thermique de celui-ci,
**caractérisé en ce que** lesdits moyens de compensation électroniques sont programmés pour l'application dudit modèle thermique avec un processus itératif dans lequel les opérations suivantes sont exécutées de manière cyclique:
- détection de la tension (V_{SH}) à travers le shunt (4, 4');
- calcul d'une valeur de courant (I_{SH}) sur la base de la valeur de tension détectée (V_{SH}) et de la valeur connue (R_{SH}) de la résistance du shunt (4, 4');
- calcul de la puissance dissipée (Pⱼ) sur la base de la valeur connue de la résistance (R_{SH}) du shunt et de la valeur calculée (I_{SH}) du courant;
- calcul de la température du shunt (θ_{SH}) en partant d'une valeur de température de référence (θ_{A}), à partir de la puissance dissipée (Pⱼ) et du temps écoulé (t), grâce au modèle thermique susdit; et
- recalcul d'une nouvelle valeur de la résistance du shunt (R_{SH}) sur la base de la valeur calculée de sa température (θ_{SH}),
lesdites opérations étant répétées de manière cyclique n fois jusqu'à ce qu'un état d'arrêt soit atteint.

2. Dispositif selon la revendication 1, dans lequel ledit état d'arrêt correspond à un état dans lequel les valeurs de courant déterminées avec deux cycles successifs d'opérations diffèrent l'une de l'autre par une quantité inférieure à une quantité présélectionnée.

3. Dispositif selon la revendication 1, **caractérisé en ce que** l'état d'arrêt susdit correspond à l'accomplissement d'un nombre présélectionné d'itérations.

4. Dispositif selon la revendication 1, **caractérisé en ce que** ledit état d'arrêt correspond à un état dans lequel les valeurs de courant déterminées avec deux cycles d'opérations successifs diffèrent l'une de l'autre par une quantité inférieure à une quantité présélectionnée ou à l'accomplissement d'un nombre présélectionné d'itérations, dans le cas où le premier état n'a pas encore été atteint.

5. Dispositif selon la revendication 1, **caractérisé en ce que** lesdits moyens de compensation électroniques sont programmés pour déterminer la valeur de courant également sur la base d'un modèle thermique, sans itérations, par détection de la variation de la température de l'élément résistif par rapport à une température de référence appropriée en fonction du temps et calcul de la valeur de courant sur la base du modèle thermique en fonction de la variation de la température avec le temps.

6. Dispositif selon l'une quelconque des revendications précédentes, **caractérisé en ce que** l'élément capteur est constitué par une plaque en cuivre (4) directement connectée à la borne de la batterie et incorporant une partie (4b) pour connexion au câble conducteur.

7. Dispositif selon l'une quelconque des revendications 1-5, **caractérisé en ce que** l'élément capteur ou de shunt est constitué par une lamelle ou bande de cuivre (4') ayant une épaisseur inférieure à la partie en cuivre terminale (40) destinée à la connexion au câble conducteur.

8. Dispositif selon la revendication 6 ou la revendication 7, **caractérisé en ce que** l'élément capteur a des encoches (10, 11, 10a, 11a, 10b, 11b) qui définissent un trajet en labyrinthe ou un trajet sinueux pour le courant qui traverse l'élément capteur.

9. Procédé pour la mesure du courant d'une batterie à bord d'un véhicule automobile, dans lequel est procurée une résistance ou shunt (4, 4'), constituée par une plaque de cuivre ayant une résistance connue pré-déterminée, connectée en série entre un terminal de la batterie et un câble conducteur associé à celle-ci, où est implanté un circuit électronique pour la mesure du courant, qui est conçu pour déterminer le courant de batterie et comprend des moyens de compensation électroniques, qui sont conçus pour corriger la valeur de courant mesurée, en prenant en compte les variations de résistance du shunt (4, 4') qui surviennent quand la température varie,
tandis que la valeur du courant est corrigée sur la base d'un modèle thermique qui représente la relation entre la puissance dissipée dans le shunt (4, 4') et l'état thermique de celui-ci,
**caractérisé en ce que** ledit modèle thermique est appliqué avec un processus itératif dans lequel les opérations suivantes sont exécutées de manière cyclique:
- détection de la tension (V_{SH}) à travers le shunt (4, 4');
- calcul d'une valeur de courant (I_{SH}) sur la base de la valeur de tension détectée (V_{SH}) et de la valeur connue (R_{SH}) de la résistance du shunt (4, 4');
- calcul de la puissance dissipée (Pⱼ) sur la base de la valeur connue de la résistance (R_{SH}) du shunt et de la valeur calculée (I_{SH}) du courant;
- calcul de la température du shunt (θ_{SH}) en partant d'une valeur de température re référence (θ_{A}), à partir de la puissance dissipée (Pⱼ) et du temps écoulé (t), grâce au modèle thermique susdit; et
- recalcul d'une nouvelle valeur de la résistance du shunt (R_{SH}) sur la base de la valeur calculée de sa température (θ_{SH}),
lesdites opérations étant répétées de manière cyclique n fois jusqu'à ce qu'un état d'arrêt soit atteint.

10. Procédé selon la revendication 9, **caractérisé en ce que** ledit modèle thermique est appliqué avec un processus non-itératif, dans lequel une température de référence initiale (θ_{A}) est détectée, la variation de température de l'élément capteur ou shunt (4, 4') (θ_{SH}) par rapport à ladite température de référence (θ_{A}) est détectée en fonction du temps, et la valeur de courant est directement calculée sur la base de la variation détectée de la température en fonction du temps.
